# EUROPÄISCHE PATENTSCHRIFT

(11) **EP 3 180 796 B1**
(45) Veröffentlichungstag und Bekanntmachung des Hinweises auf die Patenterteilung: **10.10.2018**
(21) Anmeldenummer: 15750046.3
(22) Anmeldetag: 11.08.2015
(51) Int. Cl.: H01H 1/40, H05K 1/11, H05K 1/18

(54) **ELEKTRISCHER SCHALTER**
ELECTRIC SWITCH
INTERRUPTEUR ÉLECTRIQUE

(30) Priorität: 15.08.2014 DE 102014011958
(43) Veröffentlichungstag der Anmeldung: 21.06.2017
(73) Patentinhaber: Marquardt GmbH, 78604 Rietheim-Weilheim (DE)
(72) Erfinder: ROTTLER, Frank, 78126 Königsfeld-Neuhausen (DE); BERCHTOLD, Rainer, 78532 Tuttlingen-Nendingen (DE)
(74) Vertreter: Otten, Roth, Dobler & Partner mbB Patentanwälte
(86) Internationale Anmeldenummer: PCT/EP2015/068504
(87) Internationale Veröffentlichungsnummer: WO 2016/023925

(56) Entgegenhaltungen:
- JP-A- 2007 305 384
- US-A1- 2006 254 891
- BRAND T: "SINGLE POLE PUSH SWITCH USING ELASTOMERIC ACTUATOR AND EDGE PLATED PCB", MOTOROLA TECHNICAL DEVELOPMENTS, MOTOROLA INC. SCHAUMBURG, ILLINOIS, US, Bd. 14, Dezember 1991 (1991-12), Seite 59, XP000276165, ISSN: 0887-5286

## Beschreibung

Die Erfindung betrifft einen elektrischen Schalter nach dem Oberbegriff des Patentanspruchs 1.

Ein solcher elektrischer Schalter ist aus dem Dokument Brand T: "SINGLE POLE PUSH SWITCH USING ELASTOMERIC ACTUATOR AND EDE PLATED PCB", Motorola Technical Developments, MOTOROLA INC. Schaumburg, Illinois, US, Bd. 14, Dezember 1991 (1991-12), Seite 59 bekannt. Dieser elektrische Schalter umfasst wenigstens einen Festkontakt sowie einen Schaltkontakt zur schaltenden Zusammenwirkung mit dem Festkontakt. Für den elektrischen Schalter sind zwei Festkontakte vorgesehen. Der Schaltkontakt wirkt überbrückend mit den Festkontakten zusammen. Der Schaltkontakt ist an einer Schaltmatte befindlich. Die Schaltmatte ist an einem Trägerbauteil angeordnet.

Der Schalter umfasst weiter einen als Leiterplatte dienenden Träger. Der Träger ist flächig ausgestaltet und besitzt eine Breitseite sowie eine Schmalseite. Die als Festkontakt für den elektrischen Schalter dienende Kontaktfläche ist an der stirnseitigen Schmalseite der Leiterplatte angeordnet. Die Funktionalität eines solchen Trägers ist jedoch in manchen Fällen eingeschränkt, insbesondere bei Benützung des Trägers zur Aufnahme eines elektrischen Schalters.

Weiter ist aus der US 2006/254891 A1 ein herkömmlicherweise an der Breitseite eines Trägers angeordneter elektrischer Schalter bekannt.

Der Erfindung liegt die Aufgabe zugrunde, die Funktionalität des Trägers zu erhöhen. Insbesondere soll bei Verwendung des Trägers zur Aufnahme eines elektrischen Schalters ein Schaltsignal mittels des Schalters rechtwinklig zum Träger und/oder der Leiterplatte, d.h. im wesentlichen rechtwinklig zur bisherigen Betätigungsrichtung des Schalters, erzeugt werden.

Diese Aufgabe wird bei einem gattungsgemäßen elektrischen Schalter durch die kennzeichnenden Merkmale des Anspruchs 1 gelöst.

Beim erfindungsgemäßen elektrischen Schalter ist in kompakter Bauweise das Trägerbauteil an der Stirnseite der Leiterplatte befestigt. Zwecks zuverlässiger Befestigung ist weiterhin die Leiterplatte mittels eines Rasthakens am Trägerbauteil befestigt. Vorteilhafterweise lässt sich dadurch ein elektrischer Schalter an der stirnseitigen Schmalseite des Trägers und/oder der Leiterplatte in kompakter Art und Weise anordnen. Weitere Ausgestaltungen der Erfindung sind Gegenstand der Unteransprüche.

Der Träger kann zur Aufnahme von elektrischen und/oder elektronischen Bauelementen dienen. Die Leiterplatte kann gleichzeitig mittels Leiterbahnen die elektrische Verbindung für die Bauelemente bereitstellen. Die elektrischen Leiterbahnen können sich an der Breitseite des Trägers befinden.

Zweckmäßigerweise kann der Träger aus elektrisch isolierendem Material bestehen, wobei eventuell auf dem Träger befindliche Leiterbahnen aus elektrisch leitfähigem Material bestehen. Die Kontaktfläche kann wiederum aus elektrisch leitfähigem Material bestehen. In kostengünstiger Art und Weise kann die Kontaktfläche aus einer Beschichtung mit einem elektrisch leitfähigen Metall bestehen. Zwecks Einsparung von Material kann die Beschichtung partiell an der Schmalseite ausgeführt sein. Zwecks guter elektrischer Leitfähigkeit kann es sich um eine partielle Vergoldung an der Schmalseite handeln. Eine solche Vergoldung besitzt eine geringe Neigung zur Korrosion und ist daher dauerhaft sowie funktionssicher.

Zwecks Kompaktheit kann der Schaltkontakt eine elektrisch leitfähige Pille umfassen. Die Pille kann aus Kohlenstoff, insbesondere aus Graphit, bestehen, wobei es sich hier um ein elektrisch gut leitfähiges und dennoch konstengünstiges Material handelt. Die Schaltmatte kann aus elastomeren und/oder elastischen Kunststoff, insbesondere aus Silikon, bestehen, womit die Schaltmatte in einfacher Art und Weise mittels Spritzgießen sowie besonders kostengünstig herstellbar ist. Außerdem ist eine solche Schaltmatte langlebig.

In funktionssicherer Art kann im Trägerbauteil eine Ausnehmung vorgesehen sein, derart dass die Kontaktfläche zur elektrischen Kontaktierung mit der Schaltmatte freiliegt. Zwecks einfacher Montage kann das Trägerbauteil mittels eines Anschlags an der Leiterplatte anliegen. Schließlich kann ein Fixierzapfen am Trägerbauteil zur Anordnung der Leiterplatte in einem Gehäuse vorgesehen sein, um dadurch eine einfache Positionierung und/oder Fixierung der Leiterplatte im Gehäuse zu gestatten.

Für eine besonders bevorzugte Ausgestaltung der Erfindung ist nachfolgendes festzustellen.

Geschaffen ist ein stirnseitiger Schaltkontakt auf einer Leiterplatte, so dass rechtwinklig zu der Leiterplatte ein Schaltsignal erzeugt werden kann. Hierzu ist die Leiterplatte seitlich, also an deren Stirnseite, partiell vergoldet. Das Schaltsignal wird über eine leitfähige Pille einer Schaltmatte hergestellt. Hierbei sind die Schaltmatte und die Leiterplatte über ein Trägerbauteil entsprechend positioniert.

Die mit der Erfindung erzielten Vorteile bestehen insbesondere darin, dass die Signalerzeugung mittels eines elektrischen Schalters rechtwinklig zu einer Leiterplatte ohne aufwändige sowie teure Zusatzbauteile, wie beispielsweise Lichtschranken, Kontaktbleche o. dgl., ermöglicht ist. Desweiteren kann auf eine kostenintensive, bisher verwendete Starr-Flex-Leiterplatte oder ähnliche Ausgestaltungen verzichtet werden. Der erfindungsgemäße Träger bietet eine sehr kurze Toleranzkette, was besonders vorteilhaft bei elektrischen Schaltern mit Kurzhub-Tasten oder Kurzhub-Wippen oder sonstigen Wippen und/oder Drückern ist.

Ein Ausführungsbeispiel der Erfindung mit verschiedenen Weiterbildungen und Ausgestaltungen ist in den Zeichnungen dargestellt und wird im folgenden näher beschrieben. Es zeigen
- Fig. 1: einen Träger in perspektivischer Ansicht,
- Fig. 2: ein Trägerbauteil für einen elektrischen Schalter, der mit einem Träger gemäß Fig. 1 versehen ist, und
- Fig. 3: einen elektrischen Schalter gemäß einem Schnitt entlang der Linie 3-3 in Fig. 2.

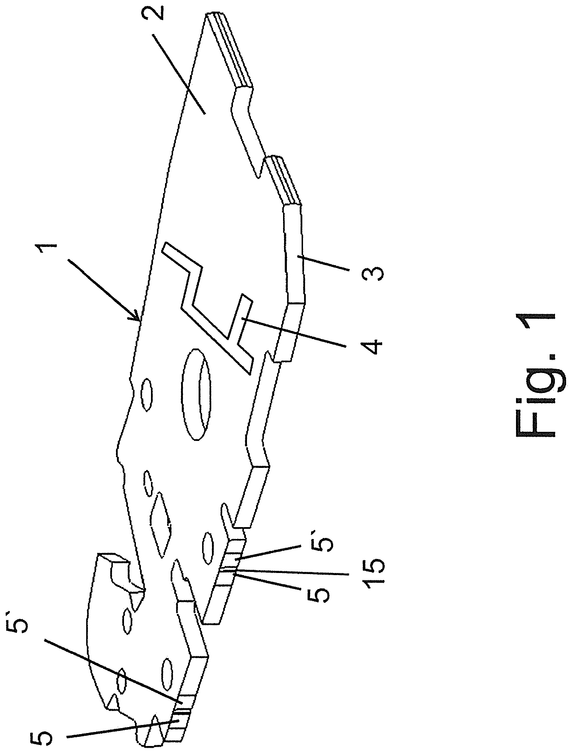

In Fig. 1 ist ein Träger 1 in der Art einer Leiterplatte zur Aufnahme von elektrischen und/oder elektronischen Bauelementen zu sehen. Der flächig ausgestaltete Träger 1 weist eine Breitseite 2 sowie eine stirnseitige Schmalseite 3 auf und besteht aus elektrisch isolierendem Material. An der Breitseite 2 des Trägers 1 befinden sich beispielsweise elektrische Leiterbahnen 4, die in Fig. 1 lediglich schematisch angedeutet sind. Bei einem dieser elektrischen Bauelemente auf dem Träger 1 handelt es sich insbesondere um einen elektrischen Schalter, für den als Festkontakt wenigstens eine freiliegende elektrisch leitfähige und somit aus elektrisch leitfähigem Material bestehende Kontaktfläche 5 auf dem Träger 1 vorgesehen ist. Diese elektrisch leitende Kontaktfläche 5 ist an der Schmalseite 3 des Trägers 1 angeordnet. Vorliegend besteht die Kontaktfläche 5 aus einer Beschichtung mit einem elektrisch leitfähigen Metall, wobei die Beschichtung partiell entsprechend der Größe der Kontaktfläche 5 vorgenommen ist. Und zwar handelt es sich bei der Kontaktfläche 5 der guten Funktionssicherheit halber insbesondere um eine partielle Vergoldung an der Schmalseite 3.

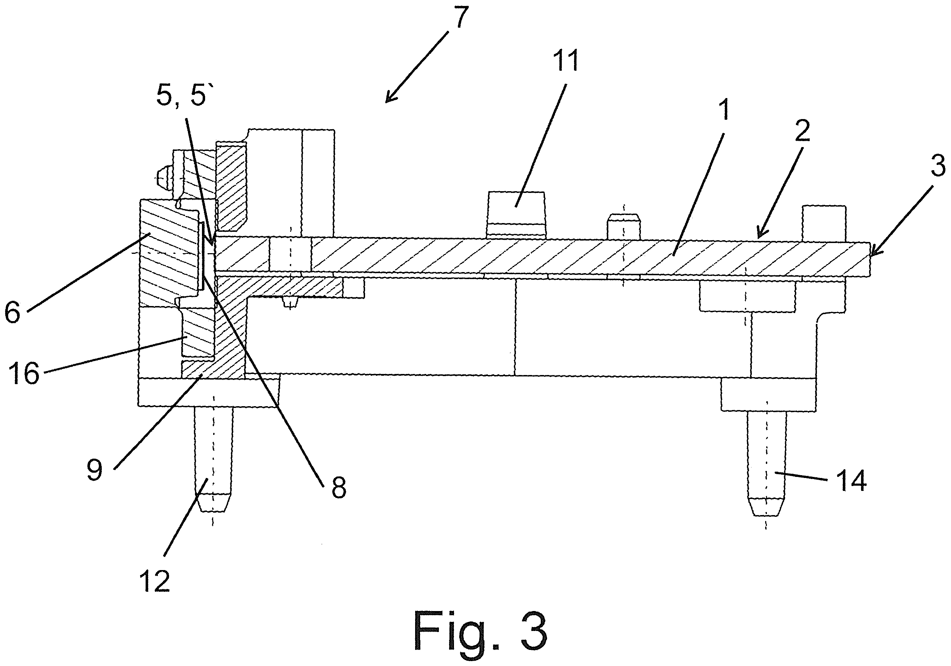

Wie bereits erwähnt kann der Träger 1 Bestandteil eines elektrischen Schalters 7 sein, welcher in Fig. 3 näher zu sehen ist. Der Schalter 7 umfasst wenigstens einen Festkontakt 5 sowie einen Schaltkontakt 6 zur schaltenden Zusammenwirkung mit dem Festkontakt 5, wobei der Festkontakt 5 als Kontaktfläche an der Schmalseite 3 der Leiterplatte 1 befindlich ist. Vorliegend sind gemäß Fig. 1 für den elektrischen Schalter 7 zwei Kontaktflächen 5, 5', die mittels einer isolierenden Fläche 15 voneinander getrennt sind, als Festkontakte vorgesehen. Der Schaltkontakt 6 wirkt dann überbrückend mit den Festkontakten 5, 5' beim Schalten zusammen.

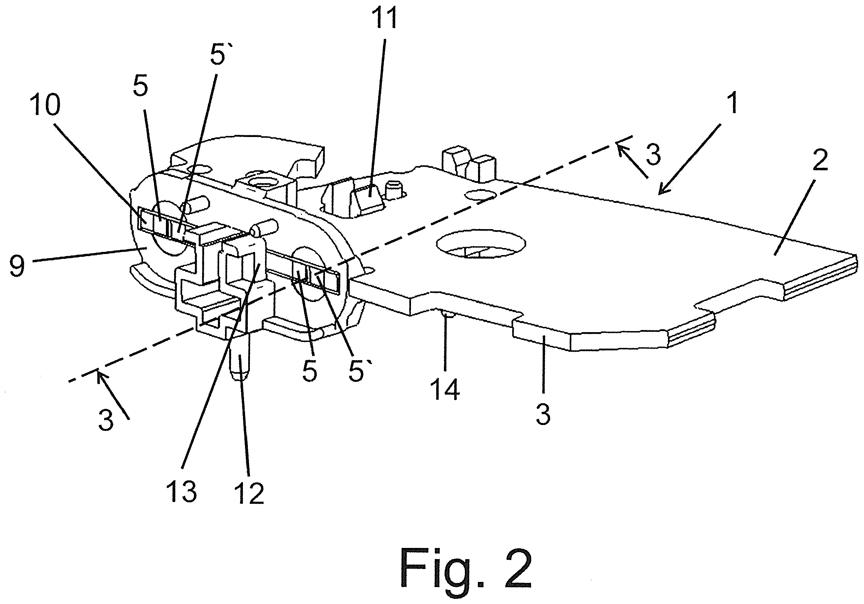

Der Schaltkontakt 6 ist gemäß Fig. 3 an einer Schaltmatte 16 befindlich. Die Schaltmatte 16 ist aus einem elastischen und/oder elastomeren Kunststoff, beispielsweise aus Silikon, hergestellt. Desweiteren umfasst der Schaltkontakt 6 eine elektrisch leitfähige Pille 8, die mit den Festkontakten 5, 5' als Kontaktstellen, an denen der elektrische Kontakt geschlossen werden kann, zusammenwirkt. Die Pille 8 besteht aus Kohlenstoff, und zwar insbesondere aus elektrisch gut leitfähigem Graphit. Die Schaltmatte 6 ist an einem Trägerbauteil 9 angeordnet, welches näher in Fig. 2 zu sehen ist. Im Trägerbauteil 9 ist eine Ausnehmung 10 vorgesehen, derart dass die Kontaktfläche 5, 5' zur elektrischen Kontaktierung mit dem Schaltkontakt 6 an der Schaltmatte 16 freiliegt.

Wie anhand von Fig. 2 zu erkennen ist, ist das Trägerbauteil 9 an der Stirnseite 3 der Leiterplatte 1 auf einen Anschlag 13 im Trägerbauteil 9 aufgeschoben. Die Leiterplatte 1 wird über ein weiteres, hier nicht dargestelltes Bauteil im Verbau bzw. bei der Montage gegen diesen Anschlag 13 gepresst. Zusätzlich ist die Leiterplatte 1 mit dem Trägerbauteil 9 über einen Rasthaken 11 befestigt. Das Trägerbauteil 9 besitzt weiterhin Fixierzapfen 12, 14 zur Befestigung und/oder Positionierung der Leiterplatte 1 mitsamt dem elektrischen Schalter 7 in einem nicht weiter gezeigten Gehäuse.

Die Erfindung ist nicht auf das beschriebene und dargestellte Ausführungsbeispiel beschränkt. Sie umfasst vielmehr auch alle fachmännischen Weiterbildungen im Rahmen der durch die Patentansprüche definierten Erfindung. So kann ein solcher Träger 1 vielfältige Verwendung finden, insbesondere in einem Schaltbedienfeld, in einem Multifunktionsschalter zur Anwahl von Funktionen o. dgl., welche wiederum in einem Kraftfahrzeug, in einem Hausgerät oder in einem sonstigen elektrischen Gerät eingesetzt werden können.

### Bezugszeichen-Liste:

- 1:: Träger / Leiterplatte
- 2:: Breitseite (des Trägers)
- 3:: Schmalseite / Stirnseite (des Trägers)
- 4:: Leiterbahn
- 5,5':: Kontaktfläche / Festkontakt
- 6:: Schaltkontakt
- 7:: (elektrischer) Schalter
- 8:: (elektrisch leitfähige) Pille
- 9:: Trägerbauteil
- 10:: Ausnehmung (im Trägerbauteil)
- 11:: Rasthaken
- 12:: Fixierzapfen (am Trägerbauteil)
- 13:: Anschlag
- 14:: Fixierzapfen (am Trägerbauteil)
- 15:: (isolierende) Fläche (an Stirnseite)
- 16:: Schaltmatte

## Patentansprüche

1. Elektrischer Schalter mit wenigstens einem Festkontakt (5) sowie einem Schaltkontakt (6) zur schaltenden Zusammenwirkung mit dem Festkontakt (5), wobei zwei Festkontakte (5, 5') vorgesehen sind, wobei der Schaltkontakt (6) an einer Schaltmatte (16) befindlich ist sowie überbrückend mit den Festkontakten (5, 5') zusammenwirkt, und wobei die Schaltmatte (16) an einem Trägerbauteil (9) angeordnet ist, und mit einer eine Breitseite (2) sowie eine Schmalseite (3) aufweisenden Leiterplatte (1), wobei die Festkontakte (5, 5') als elektrisch leitende Kontaktflächen (5) an der Schmalseite (3) angeordnet sind, **dadurch gekennzeichnet, dass** das Trägerbauteil (9) an der Stirnseite (3) der Leiterplatte (1) befestigt ist, dass das Trägerbauteil (9) mittels eines Anschlags (13) an der Leiterplatte (1) anliegt, und dass die Leiterplatte (1) mittels eines Rasthakens (11) am Trägerbauteil (9) befestigt ist.

2. Elektrischer Schalter nach Anspruch 1, **dadurch gekennzeichnet, dass** die Leiterplatte (1) als Träger für elektrische und/oder elektronische Bauelemente dient, wobei insbesondere die Breitseite (2) zur Aufnahme von elektrischen Leiterbahnen (4) vorgesehen ist.

3. Elektrischer Schalter nach Anspruch 1 oder 2, **dadurch gekennzeichnet, dass** der Träger (1) aus elektrisch isolierendem Material besteht, und dass vorzugsweise die Kontaktfläche (5) aus elektrisch leitfähigem Material besteht.

4. Elektrischer Schalter nach Anspruch 1, 2 oder 3, **dadurch gekennzeichnet, dass** die Kontaktfläche (5) aus einer Beschichtung mit einem elektrisch leitfähigen Metall besteht, und dass vorzugsweise die Beschichtung partiell, insbesondere als eine partielle Vergoldung, an der Schmalseite (3) ausgeführt ist.

5. Elektrischer Schalter nach einem der Ansprüche 1 bis 4, **dadurch gekennzeichnet, dass** der Schaltkontakt (6) eine elektrisch leitfähige Pille (8) umfasst, dass vorzugsweise die Pille (8) aus Kohlenstoff, insbesondere aus Graphit, besteht, und dass weiter vorzugsweise die Schaltmatte (16) aus elastomeren und/oder elastischen Kunststoff, insbesondere aus Silikon, besteht.

6. Elektrischer Schalter nach einem der Ansprüche 1 bis 5, **dadurch gekennzeichnet, dass** im Trägerbauteil (9) eine Ausnehmung (10) vorgesehen ist, derart dass die Kontaktfläche (5, 5') zur elektrischen Kontaktierung mit dem Schaltkontakt (6) freiliegt.

7. Elektrischer Schalter nach einem der Ansprüche 1 bis 6, **dadurch gekennzeichnet, dass** das Trägerbauteil (9) auf einen Anschlag (13) aufgeschoben ist.

8. Elektrischer Schalter nach einem der Ansprüche 1 bis 7, **dadurch gekennzeichnet, dass** ein Fixierzapfen (12, 14) am Trägerbauteil (9) zur Anordnung der Leiterplatte (1) in einem Gehäuse vorgesehen ist.

## Claims

1. Electric switch with at least one fixed contact (5) and one switching contact (6) for switching interaction with the fixed contact (5), wherein two fixed contacts (5, 5') are provided, wherein the switching contact (6) is located on a pressure-sensitive mat (16) and interacts with the fixed contacts (5, 5') in a shunting action, and wherein the pressure-sensitive mat (16) is disposed on a carrier component (9), and with a circuit board (1) having a wide side (2) and a narrow side (3), wherein the fixed contacts (5, 5') are arranged on the narrow side (3) as electrically conducting contact surfaces (5), **characterised in that** the carrier component (9) is fastened to the front end (3) of the circuit board (1), that the carrier component (9) touches the circuit board (1) by means of a stop (13), and that the circuit board (1) is fastened to the carrier component (9) with a snap-in hook (11).

2. Electric switch according to claim 1, **characterised in that** the circuit board (1) serves as the carrier for electrical and/or electronic components, wherein particularly the wide side (2) is provided to receive electrical circuit paths (4).

3. Electric switch according to claim 1 or 2, **characterised in that** the carrier (1) comprises electrically insulating material and that the contact surface (5) preferably comprises electrically conductive material.

4. Electric switch according to claim 1, 2 or 3, **characterised in that** the contact surface (5) consists of a coating of an electrically conductive material, and that the coating is preferably executed partially on the narrow side (3), particularly as partial gold plating.

5. Electric switch according to any of claims 1 to 4, **characterised in that** the switching contact (6) encompasses an electrically conductive pill (8), that the pill (8) is preferably made of carbon, particularly graphite, and the pressure-sensitive mat (16) is more preferably made of elastomers and/or elastic synthetic material, particularly silicone.

6. Electric switch according to any of claims 1 to 5, **characterised in that** a recess (10) is provided in the carrier component (9), such that the contact surface (5, 5') is exposed to electrical contact with the switching contact (6).

7. Electric switch according to any of claims 1 to 6, **characterised in that** the carrier component (9) is shunted onto a stop (13).

8. Electric switch according to any of claims 1 to 7, **characterised in that** a locating pin (12, 14) is provided on the carrier component (9) to arrange the circuit board (1) in a housing.

## Revendications

1. Interrupteur électrique comportant au moins un contact fixe (5) ainsi qu'un contact de commutation (6) destiné à coopérer en commutation avec le contact fixe (5), dans lequel deux contacts fixes (5, 5') sont prévus, dans lequel le contact de commutation (6) est arrangé à un tapis de commutation (16) et coopère avec les contacts fixes (5, 5') par pontage et dans lequel le tapis de commutation (16) est disposé sur un composant support (9) et comportant un circuit imprimé (1) présentant un côté large (2) et un côté étroit (3), dans lequel les contacts fixes (5, 5') sont disposés sous la forme de surfaces de contact électroconductrices (5) au niveau du côté étroit (3), **caractérisé en ce que** le composant support (9) est fixé sur le côté avant (3) du circuit imprimé (1), **en ce que** le composant support (9) repose au moyen d'une butée (13) sur le circuit imprimé (1) et **en ce que** le circuit imprimé (1) est fixé au moyen d'un crochet d'encliquetage (11) sur le composant support (9).

2. Interrupteur électrique selon la revendication 1, **caractérisé en ce que** le circuit imprimé (1) sert de support pour des éléments électriques et/ou électroniques, dans lequel en particulier le côté large (2) est destiné à la réception de pistes conductrices (4) électriques.

3. Interrupteur électrique selon la revendication 1 ou 2, **caractérisé en ce que** le support (1) est constitué de matériau électriquement isolant et **en ce que**, de préférence, la surface de contact (5) est constituée de matériau électroconducteur.

4. Interrupteur électrique selon la revendication 1, 2 ou 3, **caractérisé en ce que** la surface de contact (5) est constituée d'un revêtement avec un métal électroconducteur et **en ce que**, de préférence, le revêtement est réalisé partiellement, en particulier sous la forme d'un dorage partiel, sur le côté étroit (3).

5. Interrupteur électrique selon une des revendications 1 à 4, **caractérisé en ce que** le contact de commutation (6) comprend une pilule (8) électroconductrice, **en ce que**, de préférence, la pilule (8) est constituée de carbone, en particulier de graphite et **en ce que**, de préférence encore, le tapis de commutation (16) est constitué de plastique élastomère et/ou électrique, en particulier de silicone.

6. Interrupteur électrique selon une des revendications 1 à 5, **caractérisé en ce que**, dans le composant support (9), une cavité (10) est prévue, de sorte que la surface de contact (5, 5') soit exposée pour une mise en contact électrique avec le contact de commutation (6).

7. Interrupteur électrique selon une des revendications 1 à 6, **caractérisé en ce que** le composant support (9) est enfilé sur une butée (13).

8. Interrupteur électrique selon une des revendications 1 à 7, **caractérisé en ce qu'**une broche de fixation (12, 14) est prévue sur le composant support (9) pour l'agencement du circuit imprimé (1) dans un boîtier.
